# EUROPÄISCHE PATENTSCHRIFT

(11) **EP 2 113 067 B1**
(45) Veröffentlichungstag und Bekanntmachung des Hinweises auf die Patenterteilung: **28.01.2015**
(21) Anmeldenummer: 07803358.6
(22) Anmeldetag: 10.09.2007
(51) Int. Cl.: G01D 3/02, G01D 9/00

(54) **KONFIGURIERBARES FELDGERÄT FÜR DIE PROZESSAUTOMATISIERUNGSTECHNIK**
CONFIGURABLE FIELD DEVICE FOR USE IN PROCESS AUTOMATION SYSTEMS
APPAREIL DE CHAMP CONFIGURABLE POUR L'AUTOMATISATION DE PROCESSUS

(30) Priorität: 17.10.2006 DE 102006049509; 17.10.2006 DE 102006049501; 17.10.2006 DE 102006049502
(43) Veröffentlichungstag der Anmeldung: 04.11.2009
(73) Patentinhaber: Endress+Hauser GmbH+Co. KG, 79689 Maulburg (DE)
(72) Erfinder: GRITTKE, Udo, 79585 Steinen (DE); WERNET, Armin, 79618 Rheinfelden (DE); DIETERLE, Roland, 79539 Lörrach (DE); HUMPERT, Axel, 77866 Reinau (DE); FRÜHAUF, Dietmar, 79539 Lörrach (DE); GIRARDEY, Romuald, 68330 Huningue (FR); BECKER, Jürgen, 76151 Jockgrim (DE); PAULSSON, Katarina, 18135 Lidingö (SE); HÜBNER, Michael, 76199 Karlsruhe (DE)
(74) Vertreter: Andres, Angelika Maria
(86) Internationale Anmeldenummer: PCT/EP2007/059440
(87) Internationale Veröffentlichungsnummer: WO 2008/046694

(56) Entgegenhaltungen:
- EP-A- 1 108 984
- WO-A-03/098154
- DE-A1- 10 161 401

## Beschreibung

Die Erfindung betrifft ein konfigurierbares Feldgerät für die Prozessautomatisierungstechnik gemäß dem Oberbegriff des Anspruchs 1.

In der Automatisienungstechnik, insbesondere in der Prozessautomatisierungstechnik werden vielfach Feldgeräte eingesetzt, die zur Erfassung und/oder Beeinflussung von Prozessvariablen dienen. Beispiele für derartige Feldgeräte sind Füllstandsmessgeräte, Massedurchflussmessgeräte, Analysemessgeräte, Druck- und Temperaturmessgeräte etc., die als Sensoren die entsprechenden Prozessvariablen Füllstand, Durchfluss, Druck, Differenzdruck, pH-Wert bzw. Temperatur erfassen.

Zur Beeinflussung von Prozessvariablen dienen Aktoren, z. B. Ventile oder Pumpen, über die der Durchfluss einer Flüssigkeit in einem Rohrleitungsabschnitt bzw. der Füllstand in einem Behälter verändert werden kann.

Eine Vielzahl solcher Feldgeräte wird von der Firmengruppe Endress + Hauser hergestellt und vertrieben.

In der Regel sind Feldgeräte in modernen automatisierungstechnischen Anlagen über Kommunikationsnetzwerke (HART- Multidrop, Profibus, Foundation Fieldbus etc.) mit übergeordneten Einheiten (z. B. Leitsysteme, Steuereinheiten) verbunden. Diese übergeordneten Einheiten dienen zur Prozesssteuerung, Prozessvisualisierung, Prozessüberwachung sowie zur Inbetriebnahme bzw. zum Bedienen der Feldgeräte.

Notwendige Zusatzkomponenten zum Betrieb von Feldbussystemen die direkt an einen Feldbus angeschlossen sind und die insbesondere zur Kommunikation mit den übergeordneten Einheiten dienen (z. B. Remote I/Os, Gateways, Linking Devices, Controller) werden häufig auch als Feldgeräte bezeichnet.

Zum Teil sind Feldbussysteme auch in Unternehmensnetzwerke, die auf Ethernet-Basis arbeiten, integriert. So kann aus unterschiedlichen Bereichen eines Unternehmens auf Prozess- bzw. Feldgeräteinformationen zugegriffen werden.

Zur weltweiten Kommunikation können Firmennetzwerke auch mit öffentlichen Netzwerken, z. B. dem Internet verbunden sein.

Zum Bedienen und zur Inbetriebnahme der Feldgeräte sind entsprechende Bedienprogramme notwendig (z. B. FieldCare, Endress+Hauser; Pactware; AMS, Emerson; Simatic PDM, Siemens).

Zur Anlagensteuerung und -überwachung von größeren Anlagen dienen Leitsystem-Anwendungen (z. B. Simatic S7, Siemens; Freelance, ABB; Delta V, Emerson).

Ein wesentlicher Aspekt der offenen Kommunikationssysteme wie z. B. Profibus, Foundation Fieldbus oder HART ist die Interoperabilität und die Austauschbarkeit von Geräten unterschiedlicher Hersteller. So können Sensoren oder Aktoren verschiedener Hersteller problemlos zusammen eingesetzt werden. Auch ist es möglich einen Sensor eines bestimmten Herstellers durch einen funktionsgleichen Sensor eines anderen Herstellers auszutauschen.

Heutige Feldgeräte werden zunehmend komplexer. Neben der reinen Messwertverarbeitung werden Diagnoseaufgaben und vor allem Kommunikationsaufgaben, die Feldgeräte im Hinblick auf die eingesetzten Bussysteme erfüllen müssen, immer aufwendiger. Um diesen Aufgaben gerecht zu werden, sind meist mehrere Mikrocontroller in modernen Feldgeräten vorgesehen. Der Vorteil beim Einsatz von Mikrocontrollern besteht darin, dass über anwendungsspezifische Softwareprogramme, die in diesen Mikrocontrollern ablaufen, die verschiedensten Funktionalitäten realisierbar sind und Programmänderungen relativ einfach durchführbar sind. Programmgesteuerte Feldgeräte sind deshalb sehr flexibel. Diese hohe Flexibilität wird aber mit dem Nachteil erkauft, dass durch die sequentielle Programmabarbeitung die Verarbeitungsgeschwindigkeit relativ langsam ist.

Teilweise werden deshalb in Feldgeräten auch so genannte ASIC- (Application Specific Integrated Circuit) eingesetzt. Durch die anwendungsspezifische Ausgestaltung können diese Bausteine Daten/Signale sehr schnell verarbeiten. Insbesondere für rechenintensive Anwendungen sind sie sehr geeignet.

Die Funktionalität dieser Bausteine ist jedoch fest vorgegeben. Der Einsatz von ASICs lohnt sich nur bei großen Stückzahlen, da der Entwicklungsaufwand und die damit verbundenen Kosten relativ hoch sind. Eine Änderung der Funktionalität ist bei diesen Bausteine nicht möglich.

Aus der WO03/098154 ist ein konfigurierbares Feldgerät bekannt, bei dem ein rekonfigurierbarer Logikbaustein vorgesehen ist. Hier wird beim Systemstart der Logikbaustein mit mindestens einem Mikrocontroller, der auch als Embedded Controller bezeichnet wird, konfiguriert. Nachdem die Konfiguration abgeschlossen ist, wird die erforderliche Software in den Mikrocontroller geladen.

Der hierbei benötigte rekonfigurierbare Logikbaustein muss über ausreichende Ressourcen verfügen, um alle gewünschten Funktionalitäten erfüllen zu können. Solche "großen" Logikbausteine mit viel Speicherplatz benötigen jedoch entsprechend viel Energie.

Der Einsatz von kleineren Logikbausteinen mit einem geringeren Energieverbrauch würde eine erhebliche Einschränkung in der Funktionalität des jeweiligen Feldgeräte bedeuten.

Aufgabe der Erfindung ist es deshalb, ein konfigurierbares Feldgerät für die Prozessautomatisierungstechnik und ein Verfahren zum Betreiben eines solchen Feldgerätes anzugeben, das die oben genannten Nachteile nicht aufweist, das insbesondere wenig Energie verbraucht und gleichzeitig ein hohes Maß an Funktionalität aufweist.

Gelöst wird diese Aufgabe durch die im Anspruch 1 angegebenen Merkmale bzw. durch die im Anspruch 10 angegebenen Verfahrensmerkmale.

Vorteilhafte Weiterentwicklungen der Erfindung sind in den jeweiligen Unteransprüchen angegeben.

Die wesentliche Idee der Erfindung besteht darin, in einem Feldgerät einen dynamisch rekonfigurierbaren Logikbaustein vorzusehen, auf dem einzelne Funktionsmodule auf Aufforderung eines in einem Mikrocontroller ablaufenden Steuerprogramms oder einer hardwarebasierten Steuereinheit mit einer entsprechenden Ablaufsteuerung konfiguriert werden. Wenn bestimmte Funktionsmodule aktuell nicht benötigt werden, stehen deren Ressourcen für die Belegung durch andere Funktionsmodule zur Verfügung. Die partielle Rekonfiguration von FPGAs hat das Ziel, einzelne Module innerhalb der Struktur austauschen zu können. Bei einer dynamischen partiellen Rekonfiguration geschieht der Austausch während des Betriebs des Feldgeräts.

In einer Weiterentwicklung der Erfindung erfolgt die Konfiguration der Funktionsmodule mittels eines Konfigurationsbitstroms, der in den rekonfigurierbaren Logikbaustein geladen wird.

In einer Weiterentwicklung der Erfindung ist die gesamte Verarbeitungseinheit als dynamisch rekonfigurierbarer Logikbaustein ausgebildet und einen dynamischen und einen statischen Bereich aufgeteilt, wobei im statischen Bereich die Steuereinheit permanent konfiguriert ist.

In einer Weiterentwicklung der Erfindung dient mindestens ein Funktionsmodule zur Auswertung des Messsignals.

In einer Weiterentwicklung der Erfindung ist das Funktionsmodul zur Auswertung des Messsignals ein Signalfilter.

In einer Weiterentwicklung der Erfindung dient mindestens ein Funktionsmodul zur Generierung des Ausgabewerts für die Kommunikationsschaltung.

In einer Weiterentwicklung der Erfindung entspricht das Funktionsmodul zur Generierung des Ausgabewerts für die Kommunikationsschaltung einem Feldbuscontroller bzw. einem HART-Modem.

In einer Weiterentwicklung der Erfindung dient ein Funktionsmodul zur Ansteuerung einer Anzeige/Bedieneinheit.

Bei einer Weiterentwicklung der Erfindung ist das Funktionsmodul ein digitales Filter, das aus einem Basisblock und mehreren Erweiterungsblöcken besteht.

In einer Weiterentwicklung der Erfindung ist ein Logikbaustein vorgesehen, der eine Vielzahl von Logikzellen aufweist, die über elektronische Schalter verschaltet sind, wobei in einem statischen Bereich des Logikbausteins Funktionsmodule fest konfiguriert sind, wobei die Logikzellen dieser Funktionsmodule über permanente Verbindungen verschaltet sind, und einem dynamisch en Bereich Funktionsmodule zeitweise konfiguriert sind, wobei die Logikzellen dieser Funktionsmodule über elektronische Schalter zeitweise verschaltet sind.

Bei einer Weiterentwicklung des erfindungsgemäßen Verfahrens werden während der Systemstartphase folgende Verfahrensschritte durchgeführt: Konfigurierung von mindestens einem Funktionsmodul mit hoher Priorität zu einem Zeitpunkt t1, Abarbeitung dieses Funktionsmoduls, Konfigurierung von mindestens einem Funktionsmodul mit mittlerer Priorität zu einem Zeitpunkt t2, Abarbeitung dieses Funktionsmoduls, Konfigurierung von mindestens einem Funktionsmodul mit geringer Priorität zu einem Zeitpunkt t3, Abarbeitung dieses Funktionsmoduls

Bei einer Weiterentwicklung des erfindungsgemäßen Verfahrens ist die Anzahl der Logikschaltkreise mindestens eines Funktionsmoduls während der Systemstartphase und der Betriebsphase unterschiedlich.

Bei einer Weiterentwicklung des erfindungsgemäßen Verfahrens stehen Funktionsmodulen mit hoher Priorität während der Systemstartphase mehr Logikschaltkreise zur Verfügung.

Bei einer Weiterentwicklung des erfindungsgemäßen Verfahrens wird zu Beginn der Systemstartphase ein Mikroprozessor mit initialisierten Registern konfiguriert.

Bei einer Weiterentwicklung des erfindungsgemäßen Verfahrens wird ein Testmodul, das zum Testen von Funktionsmodulen und/oder Softwarefunktionalitäten des Feldgerätes dient, konfiguriert.

Bei einer Weiterentwicklung des erfindungsgemäßen Verfahrens wird das Testmodul nur während der Produktionsphase des Feldgeräts konfiguriert.

Bei einer Weiterentwicklung des erfindungsgemäßen Verfahrens wird das Testmodul zyklisch oder sporadisch auf Anforderung durch das Steuerprogramm konfiguriert.

Bei einer Weiterentwicklung des erfindungsgemäßen Verfahrens wird die Fläche, die ein Funktionsmodul auf dem rekonfigurierbaren Logikbaustein einnimmt, erweitert oder verringert.

Nachfolgend ist die Erfindung anhand eines in der Zeichnung dargestellten Ausführungsbeispiels näher erläutert.

Es zeigt:
Fig. 1: ein Blockschaltbild eines herkömmlichen Feldgerätes;
Fig. 2: ein Feldgerät mit einem rekonfigurierbaren Logikbaustein in schematischer Darstellung
Fig. 3: ein Feldgerät mit einem dynamisch rekonfigurierbaren Logikbaustein
Fig. 3a: ein Feldgerät nach Fig. 3 in einer ersten Betriebsphase in schematischer Darstellung
Fig. 3b: ein Feldgerät nach Fig. 3 in einer zweiten Betriebsphase
Fig. 3c: ein Feldgeräte nach Fig. 3 in einer dritten Betriebsphase
Fig. 4: ein Zeitdiagramm für das Laden von Modulen unterschiedlicher Priorität während der Systemstartphase

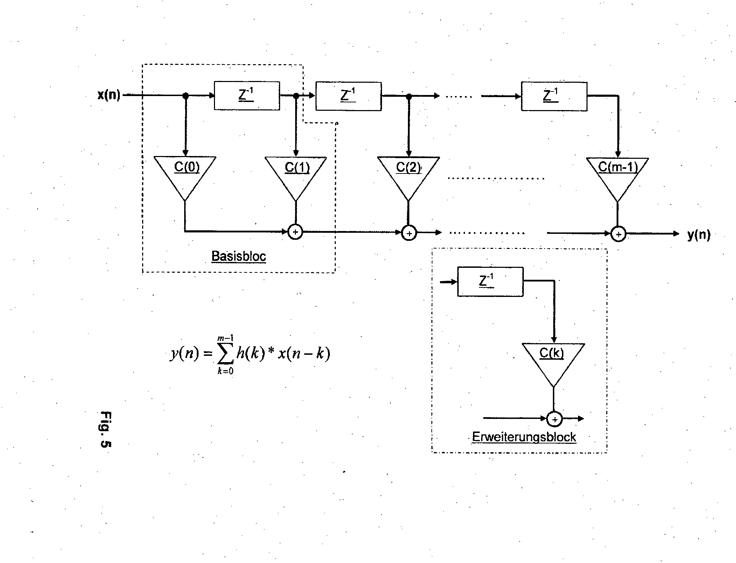

Fig. 5: ein Hardwarefilter mit mehreren Blöcken
Fig. 6: ein konfigurierbares Feldgerät mit mehreren Testmodulen

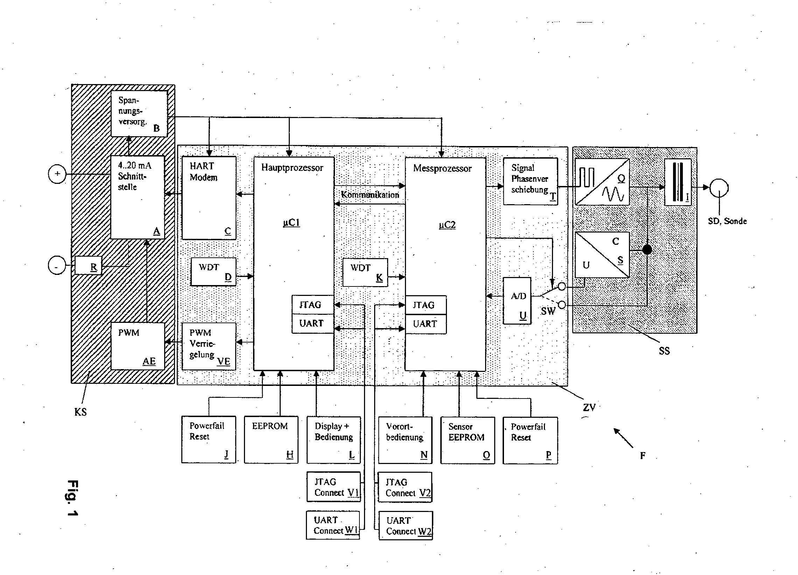

In Fig. 1 ist ein Blockschaltbild eines herkömmlichen Feldgerätes näher dargestellt. Es handelt sich dabei um ein kapazitives Füllstandsmessgerät.

Das Feldgerät F weist im Wesentlichen eine analoge Sensorschaltung SS, eine zentrale Verarbeitungseinheit ZV mit zwei Mikrocontrollern µC1 und µC2 sowie eine analoge Kommunikationsschaltung KS auf. Die analoge Sensorschaltung SS dient zur Erzeugung eines vom Füllstand abhängigen analogen Messsignals. In der Sensorschaltung SS wird mit Hilfe eines Tiefpassfilters Q aus einem Rechtecksignal ein Sinussignal (Referenzsignal) erzeugt, das über eine Trenneinheit I zu einer kapazitiven Sonde SD, die zur Erfassung der Prozessvariablen "Füllstand" dient, geführt wird. Die Trenneinheit I ermöglicht über eine kapazitive oder induktive Kopplung eine Signaltrennung und ist entsprechend der Sicherheitsanforderungen (Ex-Anforderungen) ausgelegt.

Das vom Füllstand unabhängige anregende Spannungssignal (Referenzsignal) wird in einer Wandlereinheit U digitalisiert und im Mikrocontroller µC2 ausgewertet. Alternierend wird ein füllstandabhängiges Stromsignal (Messsignal) im Mikrocontroller µC2 ausgewertet. Hierzu ist ein Strom/Spannungskonverter S notwendig, der das Stromsignal in ein Spannungssignal umwandelt, das anschließend in der Wandlereinheit U digitalisiert wird. Abwechselnd werden die beiden Signale im Mikroprozessor µC2 ausgewertet und verarbeitet. Die Umschaltung zwischen den beiden Signalen erfolgt über den Schalter SW.

Das digitale Ausgangssignal zur Generierung eines Sinussignals wird im Mikrocontroller µC2 erzeugt und über eine Phasenverschiebungseinheit T an das Filter Q weitergeleitet. Mit der Phasenverschiebungseinheit T kann die Phase des Referenzsignals entsprechend verschoben werden, um das Messsignal optimal auf die Erfordernisse der Wandlereinheit U anzupassen.

Der einwandfreie Programmablauf des Mikrocontrollers µC2 wird von einem Watchdog -Timer K überwacht. Falls ein Programmfehler auftritt, wird über den Watchdog-Timer K ein Programmreset ausgelöst.

Weiterhin sind mit dem Mikrocontroller µC2 eine Vorortbedienung N, ein Datenspeicher O und eine Powerfail-Resetschaltung P verbunden. Die Vorortbedienung N erlaubt eine einfache Einstellung von Geräteparametern, im Datenspeicher O sind Sensordaten abgespeichert und die Powerfail-Resetschaltung P löst im Falle einer Spannungsunterbrechung einen Programmreset aus.

Neben dem Mikroprozessor µC2, der im Wesentlichen zur Auswertung des Messsignals dient, ist ein weiterer Mikrocontroller µC1 vorgesehen, der zur Generierung der Ausgabewerte für die Prozessvariable und zur eigentlichen Steuerung des Feldgeräts F dient. Mit dem Mikrocontroller µC1 ist ebenfalls ein Watchdog - Timer D und eine Power-Resetschaltung J verbunden. Ferner sind mit dem Mikrocontroller µC1 ein Datenspeicher H, eine Anzeige/Bedieneinheit L, ein Modem C und eine Verriegelungseinheit VE verbunden.

Dem Modem C ist die Kommunikationsschaltung KS nachgeschaltet, die zum Anschluss an eine Prozessregelschleife (2-wire-control-loop) dient.

Im vorliegenden Fall ist das Feldgerät F für eine HART-Kommunikation ausgelegt. Bei dem Modem C handelt es sich deshalb um ein HART-Modem. Auch die Kommunikationsschaltung KS ist für die HART-Kommunikation angepasst und weist eine 4-20 mA Schnittstelle A und einen HART-Kommunikations-Widerstand R auf.

Über ein 4-20mA-Stromsignal kann der Messwert als Ausgabewert des Feldgerätes an eine externe Einheit über die Prozessregelschleife übertragen werden. Als externe Einheit ist zum Beispiel eine speicherprogrammierbare Steuerung denkbar, die den Ausgabewert verarbeitet und Aktoren entsprechend ansteuert.

Über die 4-20mA-Schnittstelle A wird das Feldgerät F auch mit Energie versorgt. Hierzu dient eine Spannungsversorgungsschaltung B, an die die einzelnen energieverbrauchenden Komponenten des Feldgerätes F angeschlossen sind.

Den Stellwert für das 4-20mA Stromsignal gibt der Mikrocontroller µC1 als pulsweiten-moduliertes Signal (PWM-Signal) aus. Eine Verriegelungseinheit VE stellt, falls ein Reset vorliegt, das Tastverhältnis des PWM-Signals auf 0% ein. Über eine Ansteuereinheit AE wird die 4-20mA-Schnittstelle A so angesteuert, dass das gewünschte Stromsignal über die Prozessregelschleife übertragen wird.

Zu Testzwecken weisen beide Mikroprozessoren µC1 und µC2 jeweils eine standardisierte JTAG-Schnittstelle mit den entsprechenden Anschlüssen V1 bzw. V2 auf.

Zur Kommunikation weisen beiden Mikroprozessoren µC1, µC2 jeweils noch eine standardisierte serielle UART-Schnittstelle mit entsprechenden Anschlüssen W1 bzw. W2 auf.

In den Mikroprozessoren µC1. und µC2 laufen die entsprechenden Anwendungsprogramme (Firmware) ab. Diese Anwendungsprogramme bestehen aus einer Vielzahl von Programmkomponenten, wie Messwertverarbeitung, Diagnose, Bedienmenü etc.

Der punktiert hinterlegte Teil stellt den Bereich des Feldgerätes F dar, in dem Daten in digitaler Form verarbeitet werden. Der restliche Bereich (gestrichelt hinterlegt) ist der Analog-Bereich mit mehreren analogen Schaltungskomponenten als externe Komponenten.

Häufig sind Teile des Modems C und der Kommunikationsschaltung KS in einem ASIC realisiert.

Nachfolgend ist die Funktion dieses herkömmlichen Feldgerätes näher erläutert.

Das Feldgerät F dient zur Bestimmung des Füllstandes einer Flüssigkeit in einem Behälter. Der Füllstand ist für die Prozesssteuerung die entscheidende Prozessvariable.

Mit dem Füllstand ändert sich die Kapazität der Sonde SD. Ermittelt wird die Kapazität mit Hilfe der Sensorschaltung SS, die zwei analoge Signale (Referenzsignal/Messsignal) ausgibt, die in der Wandlereinheit U in digitale Signale umgewandelt werden. Ausgewertet werden die digitalen Signale in der Verarbeitungseinheit ZV und zwar im Mikrocontroller µC2, in dem ein spezielles Auswerteprogramm für das Messsignal/Refenzsignal abläuft. Nach der Auswertung steht z. B. der aktuelle Füllstand bzw. die Füllmenge in dem betreffenden Behälter als Ausgabewert zur Verfügung. Dieser Messwert kann über die analoge Kommunikationsschaltung KS und die Prozessregelschleife an eine externe Einheit weitergeleitet werden.

Die Verarbeitungseinheit ZV dient im Wesentlichen zur Auswertung des Messsignals, zur Generierung des Ausgangssignals für die Prozessvariable und zur Steuerung des Feldgerätes F. Zur Durchführung dieser Aufgaben werden in den beiden Mikrocontrollern µC1 und µC2 entsprechende Programme abgearbeitet.

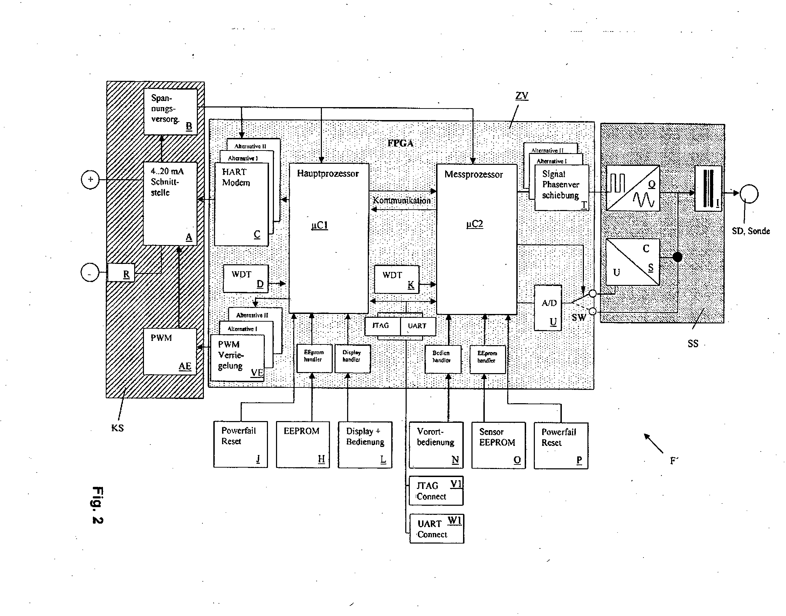

In Figur 2 ist ein Blockschalbild eines konfigurierbaren Feldgeräts F' mit einem rekonfigurierbaren Logikbaustein FPGA (field programmable gate array) dargestellt, das in der Funktion dem Feldgerät nach Fig. 1 entspricht. Im Prinzip sind alle Komponenten der zentralen Verarbeitungseinheit ZV nach Fig. 1 auf dem rekonfigurierbaren Logikbaustein FPGA konfiguriert. Für einzelne bereits beim Feldgerät nach Figur 1 vorhandene Komponenten sind zusätzlich Alternativen dargestellt. So zum Beispiel für das HART-Modem C wo als Alternative ein Profibus- oder Foundation Fieldbus-Controller denkbar sind, für die Verriegelungseinheit VE und für die Phasenverschiebungseinheit T. Für die Ansteuerung der Komponenten Datenspeicher EEPROM, Anzeigebedieneinheit L, Vorortbedienung N und Sensordatenspeicher O sind zusätzlich entsprechende Ansteuerungen, die auch als "handler" bezeichnet werden, vorgesehen.

Dieses Feldgerät F' kann für unterschiedliche alternative Anwendungen konfiguriert werden. Ein wesentlicher Nachteil dieses Feldgerätes liegt jedoch in dem hohen Ressourcenbedarf und dem damit verbundenen hohen Energiebedarf.

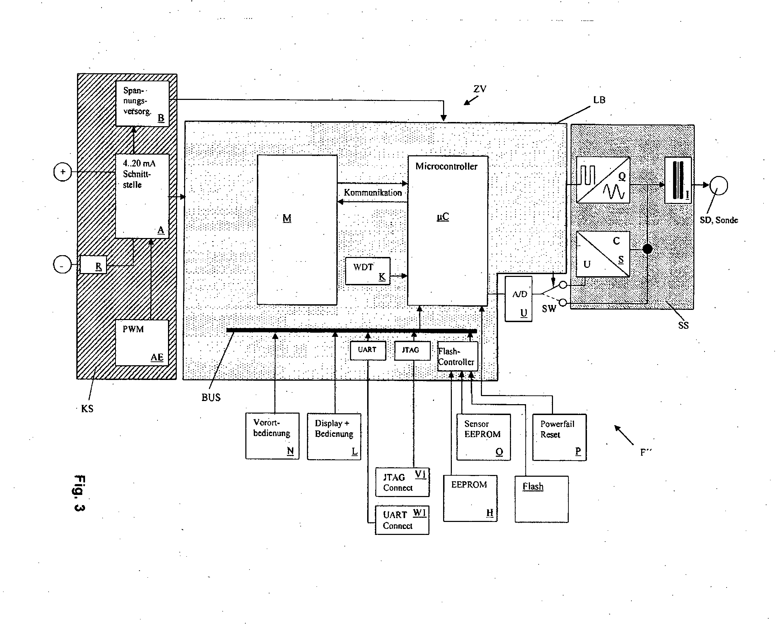

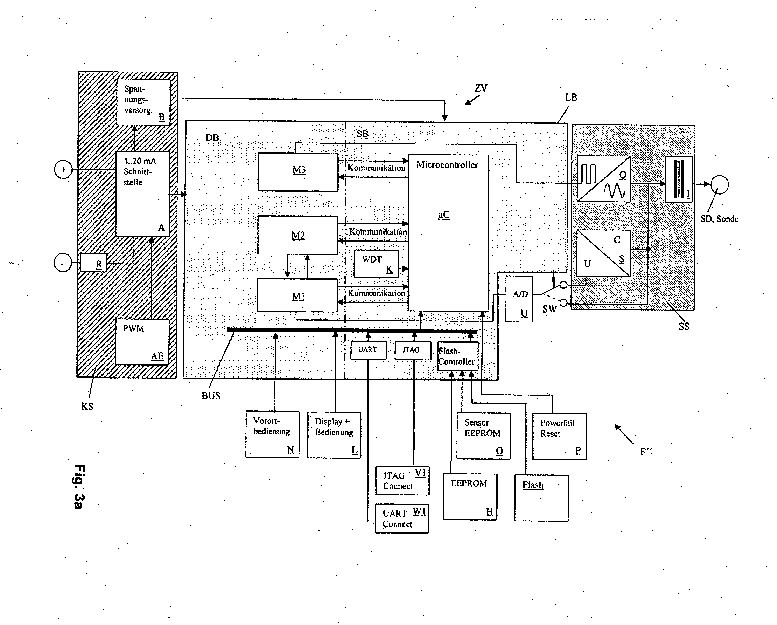

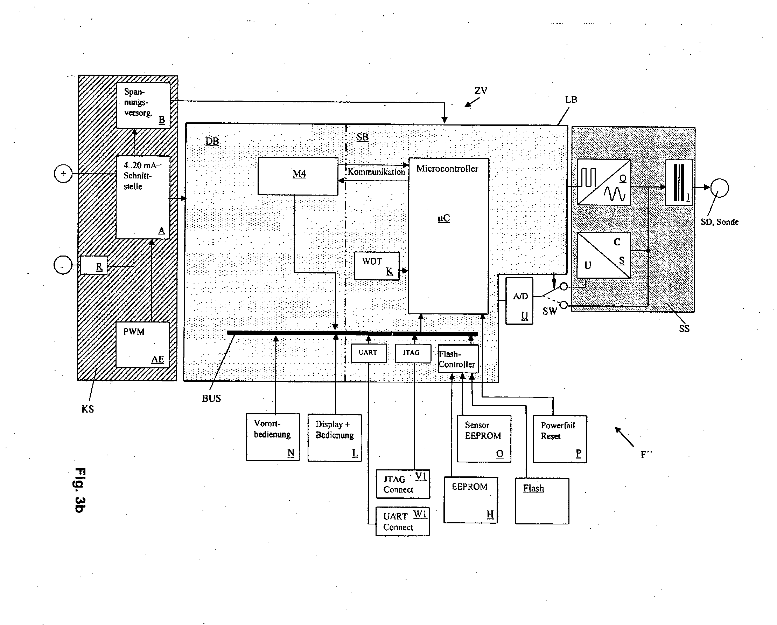

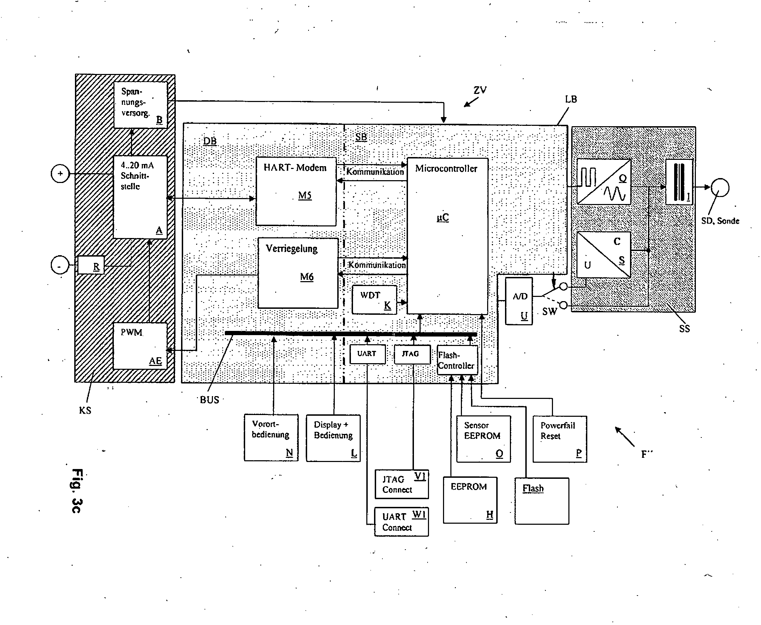

In Fig. 3 ist ein erfindungsgemäßes Feldgerät F" näher dargestellt. Es weist die gleichen externen Komponenten wie die in Fig. 1 bzw. Fig. 2 dargestellten Feldgeräte F, F' auf. Der wesentliche Unterschied besteht jedoch darin, dass die Verarbeitungseinheit ZV als dynamisch rekonfigurierbarer Logikbaustein LB ausgebildet ist. Auf dem Logikbaustein LB sind ein Mikrocontroller µC, ein Funktionsmodul M sowie ein Watchdog-Timer K, zwei Schnittstellen JTAG und UART sowie ein Controller für einen Speicher FLASH konfiguriert.

In den Figuren Fig. 3a - Fig. 3c ist das erfindungsgemäße Feldgerät F" nach Fig. 3 während unterschiedlicher Betriebsphasen näher dargestellt. In allen drei Figuren sind der Übersichtlichkeit halber nur die während der betreffenden Betriebsphase tatsächlich benötigten Komponenten des Feldgerätes F" gezeigt.

Der Logikbaustein LB ist in zwei Bereiche, einen dynamischen Bereich DB und einen statischen Bereich SB unterteilt. Im statischen Bereich ist ein Mikrocontroller µC permanent konfiguriert, der über einen Peripheriebus mit der UART-Schnittstelle, der JTAG-Schnittstelle und dem Controller für den Speicher FLASH kommuniziert.

Im dynamischen Bereich DB sind ein oder mehrere Funktionsmodule konfiguriert. Die Kommunikation dieser Module mit dem Mikrocontroller µC erfolgt über Hardware-FIFO-Kanäle (Fast Simplex Links).

Die einzelnen Funktionsmodule können über entsprechende Konfigurations-Bitströme separat und zur Laufzeit dynamisch konfiguriert werden. Normalerweise sind die Konfigurations-Bitströme in dem externen Speicher FLASH abgespeichert. Der Ladevorgang wird durch ein entsprechendes Steuerprogramm im Mikrocontroller µC eingeleitet.

Das Feldgerät nach Fig. 3a ist während einer ersten Phase, der eigentlichen Messphase, dargestellt. Deshalb sind auch nur die Funktionsmodule, die für die Auswertung des Messsignals notwendig sind, konfiguriert. Dies sind ein Amplituden-und Phasen-Berechnungs-Modul M1, ein Kapazitätsberechnungs-Modul M2 sowie ein Phasenverschiebungs-Modul M3. Als externe Hardwarekomponenten sind während dieser Betriebsphase das Tiefpassfilter Q, die Trenneinheit I, die Sonde SD, die Wandlereinheit U, der Schalter SW und der Strom/Spannungskonverter S aktiv.

Alle weiteren externen Hardwarekomponenten werden aktuell nicht aktiv angesprochen. Sie benötigen somit entweder gar keine Energie oder nur minimal Energie.

Da insbesondere die Funktionsmodule M1 und M2 für parallele Datenverarbeitung ausgelegt sind, kann die Messsignalauswertung entsprechend schnell erfolgen.

In Fig. 3b ist das Feldgerät während einer weiteren zweiten Phase, in der der Anwender das Gerät bedienen kann, dargestellt. Hierfür ist als Funktionsmodul ein Anzeige/Bedienungs-Modul M4 konfiguriert, das die Anzeige/Bedieneinheit L ansteuert.

Dem Anwender steht zu diesem Zeitpunkt die volle Anzeige/Bedien-Funktionalität des Feldgeräts zur Verfügung.

Dieses Funktionsmodule M4 kann z. B. auf den frei gewordenen Ressourcen des aktuell nicht benötigten Funktionsmoduls M2 für die Amplituden- und Phasenberechnung konfiguriert werden.

Während dieser zweiten Phase findet keine Messsignalauswertung statt. Es wird deshalb für diese Funktionalität momentan auch keine Energie verbraucht.

Es besteht auch die Möglichkeit, dass die Messsignalauswertung nicht komplett ausgeladen wird, sondern nur reduziert wird, wenn das Anzeige/Bedienungs-Modul M4 geladen wird.

In Fig. 3c ist das Feldgerät F während einer dritten Phase dargestellt. In dieser Phase findet eine Kommunikation mit einer externen Einheit statt. Hierfür werden alle Funktionsmodule, die für die Kommunikation notwendig sind, konfiguriert. Dies sind hier das Funktionsmodul HART-Modem M5 und das Verriegelungs-Modul M6.

Nachfolgend ist die Funktionsweise des erfindungsgemäßen Feldgerätes nochmals erläutert. Die aktuell benötigten Funktionsmodule werden auf Aufforderung des im Mikrocontroller µC ablaufenden Steuerprogramms auf dem Logikbaustein LB dynamisch konfiguriert. Die Konfigurierung der Funktionsmodule M1-M6 erfolgt in einfacher Weise über einen Konfigurationsbitstrom der aus dem Speicher FLASH geladen wird.

Als sehr vorteilhaft hat es sich erwiesen, auf dem dynamisch rekonfigurierbaren Logikbaustein LB zwei Bereiche vorzusehen, eine dynamischen und ein statischen Bereich. Der statische Bereich SB ist permanent als Steuereinheit (Mikrocontroller µC) konfiguriert, in dem das Steuerprogramm abläuft. Der dynamische Bereich DB ist für die einzelnen Funktionsmodule vorgesehen. Einzelne Funktionsmodule könne sukzessive im gleichen Bereich konfiguriert werden, so dass der dynamische Bereich-trotz hoher Funktionalität - kompakt ausgestaltet sein kann.

Die Funktionsmodule M1-M6 decken verschiedene Funktionalitäten wie Auswertung des Messsignals, Generierung eines Ausgabewertes für die Kommunikations schaltung, Signalfilter für das Messsignal, Ansteuerung der Anzeige/Bedieneinheit ab.

Ein Feldgerät mit einem dynamisch rekonfigurierbaren Logikbaustein bietet den Vorteil, dass nur aktuell benötigte Funktionsmodule konfiguriert werden müssen.

Dies erlaubt die Verwendung von relativ kleinen Logikbausteinen mit wenig Speicherplatz. Solche kleinen Logikbausteine benötigen entsprechend wenig Energie.

Alle weiteren Funktionalitäten stehen prinzipiell zur Verfügung, da sie als Funktionsmodule im Speicher FLASH gespeichert sind und jederzeit konfiguriert werden können, soweit entsprechende Ressourcen frei sind.

Das erfindungsgemäße Feldgerät benötigt relativ wenig Energie und erlaubt trotzdem ein hohes Maß an Funktionalität. Außerdem erlaubt es eine sehr schnelle Datenverarbeitung, weil für aktuell benötigte Funktionalitäten alle Ressourcen des dynamischen Bereichs DB zur Verfügung stehen und damit eine parallele Verarbeitung möglich wird.

Aufgrund des geringen Energieverbrauchs kann das Feldgerät F" z. B. über einen Feldbus bzw. eine Prozessregelschleife mit Energie versorgt werden (loop powered) ohne dass eine separate Energieversorgungsleitung notwendig ist.

### Inkrementelles Zuschalten von Funktionsmodulen

Feldgeräte mit dynamisch rekonfigurierbaren Logikbausteinen bieten noch weitere Vorteile. So können z. B. bei einem Systemstart (Startup) entweder alle Funktionsmodule gleich von Anfang an geladen werden oder aber die Funktionsmodule werden zeitlich verzögert entsprechend ihrer Priorität geladen. Bei der ersten Alternative stehen alle Funktionen des Feldgerätes unmittelbar nach dem Systemstart zur Verfügung.

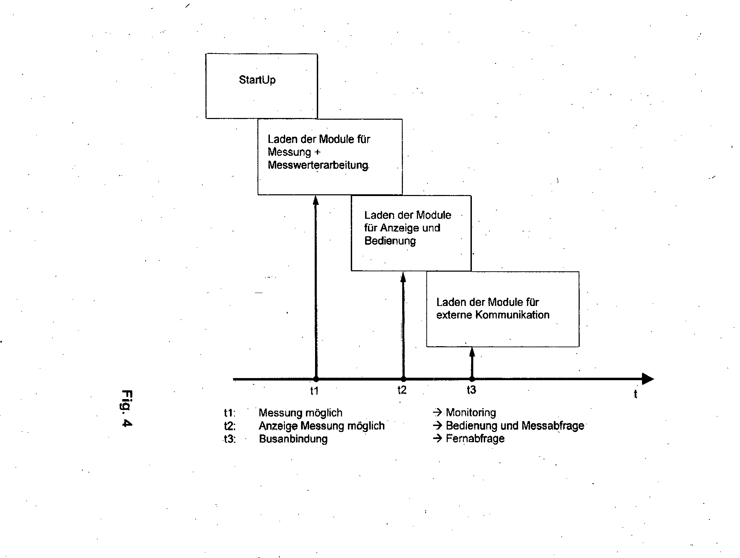

Die zweite Alternative bietet jedoch den Vorteil, dass der Messwert schnell zur Verfügung steht. Hierzu werden nach dem Systemstart nur die Funktionsmodule, die für die Auswertung des Messsignals notwendig sind (z. B. M1, M2, M3) und deshalb eine hohe Priorität haben, geladen. Anschließend wird das Anzeige/Bedienungs-Modul M4 geladen, das eine mittlere Priorität hat, und zu letzt werden die Module, die eine geringe Priorität haben, wie z. B. die Module, die für die Kommunikation benötigt werden (z. B. M5, M6), geladen. Diese zeitliche Verzögerung beim Laden der Funktionsmodule ist in Fig. 4 dargestellt. Wenn das Feldgerät kurz nach dem Zeitpunkt t1 wieder abgeschaltet wird, kann die Energie, die zum Laden der nachfolgenden Funktionsmodule benötigt werden würde, eingespart werden. Ein weiteres Energieeinsparpotential besteht darin für den Systemstart mehr Ressourcen zur Verfügung zu stellen, indem die Struktur der Funktionsmodule auf einen schnellen Systemstart zugeschnitten ist. So kann z. B. die Fläche, die dem Anzeige/ Bedienungs-Modul anfänglich zur Verfügung gestellt wird, relativ klein sein. Zu einem späteren Zeitpunkt kann die Fläche dann vergrößert werden. Die Fläche die ein Funktionsmodule auf dem Logikbaustein einnimmt d. h. die Anzahl der Logikschaltkreise, ist mit der Funktionalität des betreffenden Moduls direkt korreliert. Kleine Fläche bedeutet weniger Funktionalität bzw. weniger Performance was z. B. langsamere Verarbeitungsgeschwindigkeit zur Folge hat.

Rekonfigurierbare Logikbausteine bieten sogar den Vorteil, Mikrocontroller mit einem vollständig initialisierten Register zu laden. Dadurch entfällt die normalerweise notwendige Initialisierungsphase, was sich ebenfalls energiesparend auswirkt.

### Adaptive Hardware

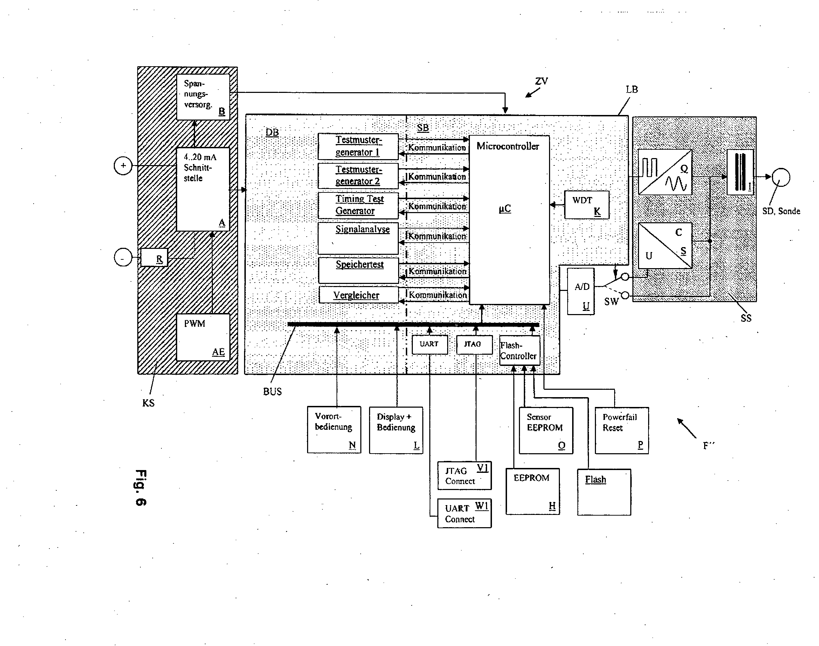

Ein weiterer Vorteil, den dynamisch rekonfigurierbare Logikbausteine bieten, ist die Möglichkeit, Hardwarekomponenten dynamisch anzupassen. Als Beispiel sei ein digitales Filter angegeben, das eine Differenzengleichung mit n Summanden repräsentiert (Fig. 6). Das Filter kann aus einem Basisblock und mehreren identischen Erweiterungsblöcken aufgebaut werden. Mehr Erweiterungsblöcke bedeuten eine verbesserte Filterfunktion verbunden mit einem entsprechend größeren Energieverbrauch. Gemäß den gewünschten Anforderungen im Hinblick auf Energieverbrauch, Performance, zur Verfügung stehende Fläche werden mehr oder weniger Erweiterungsblöcke auf dem dynamisch rekonfigurierbaren Logikbaustein konfiguriert.

Das Filter auf dem dynamisch rekonfigurierbaren Logikbaustein wird somit an die momentanen Anforderungen adaptiert.

Die Adaption kann von unterschiedlichen Kriterien abhängen, z. B. Signal/ Rauschabstand, zur Verfügung stehende Energie, zyklische Wiederholungen, Geschwindigkeit der Verarbeitung etc..

Ein weiteres Beispiel, eine adaptive Hardware sinnvoll einzusetzen, ist die Echoverfolgung bei Radarfüllstandsmeßgeräten. Hier wird das Nutzechosignal aus dem Echosignal ermittelt. Neben dem Nutzechosignal weist das Echosignal meist noch Störechos und einen Rauschpegel auf. Je später das Nutzechosignal im Echosignal auftritt, je größer also der zu messende Abstand ist, desto kleiner ist die Amplitude des Nutzechosignals. Zur sicheren Identifizierung des Nutzechosignals wird dieses über mehrere Messungen verfolgt. Die Echokurven können dabei in einem 3-dimensionalen Räum als Echofeld dargestellt werden, in dem die zeitliche Verschiebung des Nutzechos verfolgt werden kann.

Bei einer Filterung über das Echofeld kann es sinnvoll sein, das Filter z. B. nach jeweils 100 Messungen zyklisch anzupassen.

Ein weiteres Beispiel für den Einsatz einer adaptiven Hardware bietet die kapazitive Füllstandsmesstechnik. Teilweise werden hier Feldgeräte eingesetzt, die mit unterschiedlichen Frequenzen arbeiten. Zur Ansatzermittlung bzw. zur DK-Berechnung wird sporadisch auf eine hohe Frequenz umgeschaltet. Hier kann entsprechend der Frequenz die Abtastrate bzw. die Anzahl der Erweiterungsblöcke angepasst werden.

Auch bei einer Fouriertransformation ist eine adaptive Hardware ebenfalls vorteilhaft. Die Fouriertransformation kann wie ein Filter ebenfalls über einen Basisblock und mehrere Erweiterungsblöcke harwaremäßig auf dem dynamisch rekonfigurierbaren Logikbaustein realisiert werden.

Tauchen in einem Fourierspektrum neue Frequenzspitzen auf, so kann eine Anpassung des Transformationsverhalten durch zusätzliche Erweiterungsblöcke erfolgen.

### Dynamische Testfunktionen als Testmodule

Einen weiteren Vorteil den Feldgeräte mit dynamisch rekonfigurierbaren Logikbausteinen bieten, ist im Hinblick auf das Testen von Funktionen eines Feldgerätes zu sehen.

Hierzu werden Testmodule als Funktionsmodule auf den dynamisch rekonfigurierbaren Logikbaustein geladen. Als Testmodule sind Speichertestmodule, Signalsanalysemodule, Vergleichermodule, Timing-Test-Generator-Module oder Testmustergeneratoren-Module etc. denkbar, die in den dynamischen Bereich DB des Logikbausteins LB geladen werden (Fig. 7).

Die Testmodule können z. B. nur während der Produktionsphase des Feldgerätes eingesetzt werden, um bestimmte Funktionalitäten des Feldgerätes zu testen.

Alternativ können zum Testen während des Betriebs des Feldgeräts Testmodule zyklisch, sporadisch oder auf Anforderung aufgerufen werden.

In vorteilhafter Weise ist für Tests in der Produktionsphase ein Testtemplate vorgesehen, das verschiedene passend vordefinierte Bereiche (Slots) für Testmodule vorsieht.

Die Slots weisen bereits definierte Schnittstellen zum Mikrocontroller µC auf und besitzen eine vordefinierte Größe. In die Slots werden dann die jeweiligen Testmodule geladen.

In einen Slot für Speichertestmodule können verschiedene Module, je nach angeschlossenem Speichermodul geladen werden. Als Beispiele für entsprechende Algorithmen seien genannt; Walking Pattern, Marching Pattern, descrambelt; nicht descrambelt etc..

Eine Vereinfachung bei Testmodulen ist möglich, wenn mit Hilfe des Mikrocontrollers µC und eines rückgekoppelten Schieberegisters im Ein-/Ausgabe-Bereich I/O Bereich die Ergebnisse des Tests über eine Signaturanalyse bewertet werden.

Durch die große Rechenleistung der Verarbeitungseinheit ZV u. a. durch die parallele Datenverarbeitung (Parallelverarbeitung) sind umfangreiche und komplizierte Signalanalysen in sehr kurzer Zeit möglich. Auf das Antwortsignal eines Testsignals kann z. B. eine Fourriertransformation angewendet werden, um das Signal gleich im Frequenzbereich zu analysieren.

Grundsätzlich ist es möglich, für die meisten denkbaren Testfälle entsprechende Testmodule zu generieren. Typischerweise lassen sich für Feldgeräteklassen bzw. Feldgerätefamilien eines Feldgeräteherstellers wiederkehrende Testanforderungen definieren, die durch Testtemplates abgedeckt werden können.

Neben Tests während der Produktionsphase sind auch Tests während des Betriebs des Feldgerätes von entscheidender Wichtigkeit im Hinblick auf die Sicherheit der gesamten Anwendung in der das Feldgerät eingesetzt wird. Steht aktuell zu wenig Fläche für ein Testmodul zur Verfügung, so kann die Fläche anderer Funktionsmodule kurzzeitig verringert werden um Fläche für das benötigte Testmodul zu schaffen. Das Nachladen der Testmodule kann wie bereits oben erwähnt, zyklisch, sporadisch oder auf Anforderung erfolgen. Nach Abschluss eines Tests werden die Testmodule wieder entfernt.

Testmodule sind von großer Wichtigkeit für selbstlernende Systeme, bei denen Parameter mit Hilfe von Testmodulen überwacht und protokolliert werden. Damit können auch Voraussagen über die Verfügbarkeit gemacht werden.

Testmodule können auch einfach verändert werden, z. B. parameterabhängig, lebensdauerabhängig, leistungsangebotsabhängig, temperaturabhängig etc.

Wird über einen Test mit Hilfe eines Testmoduls festgestellt, dass einzelne Zellen des dynamisch rekonfigurierbaren Logikbaustein fehlerhaft sind, können diese nochmals überschrieben werden oder der Bereich dieser fehlerhaften Zellen zukünftig gemieden werden. Dies ist insbesondere bei Anwendungen mit hoher Strahlenbelastung vorteilhaft, wo es leicht zu Zellenfehler durch Strahlungseinflüsse ("Umwerfen der Zelle") kommen kann.

Dadurch wird die Verfügbarkeit des Feldgerätes drastisch erhöht.

Einen weiteren Vorteil den Testmodule ermöglichen ist die Selbstkalibration des Feldgerätes. Entsprechende Testmodule für die Selbstkalibration können zur Prüfung von Teilfunktionen des Feldgeräts eingesetzt werden, um so Rückschlüsse über den "Zustand" dieser Teilfunktionen zu gewinnen.

### Bezugszeichenliste

**Tabelle 1**

| | |
|---|---|
| 4-20 mA Schnittstelle | A |
| Amplituden-und Phasen-Berechnungs-Modul | M1 |
| Anschlüsse UART | W1, W2 |
| Anschlüsse JTAG | V1, V2 |
| Ansteuereinheit | AE |
| Anzeige/Bedieneinheit | L |
| Anzeige/Bedien-Modul | M4 |
| Datenspeicher | H |
| Datenspeicher | O |
| Dynamischer Bereich | DB |
| Feldgerät | F, F', F" |
| HART-Modem-Modul | M5 |
| JTAG-Schnittstelle | JTAG |
| Kapazitätsbereiclinungs-Modul | M2 |
| Kommunikationsschaltung | KS |
| Logikbaustein | LB |
| Mikrocontroller | µC1 |
| Mikrocontroller | µC2 |
| Modem | C |
| Phasenverschiebungseinheit | T |
| Phasenverschiebungs-Modul | M3 |
| Power-Resetschaltung | P |
| Power-Resetschaltung | J |
| Schalter | SW |
| Sensorschaltung | SS |
| Sonde | SD |
| Spannungsversorgungsschaltung | B |
| Speicher | FLASH |
| Statischer Bereich | SB |
| Strom/Spannungskonverter | S |
| Tiefpassfilters | Q |
| Trenneinheit | I |
| UART-Schnittstelle | UART |
| Verarbeitungseinheit | ZV |
| Verriegelungseinheit | VE |
| Verriegelungs-Modul | M6 |
| Vorortbedienung | N |
| Wandlereinheit | U |
| Watchdog-Timer | K |
| Watchdog-Timer | D |

## Patentansprüche

1. Konfigurierbares Feldgerät für die Prozessautomatisierungstechnik zur Bestimmung einer Prozessvariablen
mit einer analogen Sensorschaltung (SS), die mit einer Sonde (SD) zur Erfassung der Prozessvariablen verbindbar ist und die ein von der erfassten Prozessvariablen abhängiges analoges Messsignal ausgibt,
einer der Sensorschaltung (SS) nach geschalteten Wandlereinheit (U) zur Umwandlung des analogen Messsignals in ein digitales Messsignal,
einer mit der Wandlereinheit (U) verbundenen Verarbeitungseinheit (ZV) in der Funktionsmodule vorgesehen sind, die zur Auswertung des Messsignals, zur Generierung eines Ausgabewertes für die Prozessvariable und zur Steuerung des Feldgerätes dienen
und einer mit der Verarbeitungseinheit (ZV) verbundenen analogen Kommunikationsschaltung (KS), die zur Weiterleitung des Ausgabewertes an eine externe Einheit dient,
**dadurch gekennzeichnet, dass** die Verarbeitungseinheit (ZV) einen partiell dynamisch rekonfigurierbaren Logikbaustein (LB) umfasst, auf dem Funktionsmodule auf Anforderung eines in einer Steuereinheit (µC) ablaufenden Steuerprogramms konfiguriert werden.

2. Konfigurierbares Feldgerät nach Anspruch 1, **dadurch gekennzeichnet, dass** die Konfiguration der Funktionsmodule mittels eines Konfigurationsbitstroms erfolgt, der in den rekonfigurierbaren Logikbaustein (LB) geladen wird.

3. Konfigurierbares Feldgerät nach Anspruch 2, **dadurch gekennzeichnet, dass** die gesamte Verarbeitungseinheit (ZV) als partiell dynamisch rekonfigurierbarer Logikbaustein (LB) ausgebildet ist und einen dynamischen und einen statischen Bereich aufweist, wobei im statischen Bereich (SB) die Steuereinheit, bei der es sich bevorzugt um einen Mikrocontroller (µC) handelt, permanent konfiguriert ist.

4. Konfigurierbares Feldgerät nach Anspruch 3, **dadurch gekennzeichnet, dass** mindestens ein Funktionsmodul zur Auswertung des Messsignals dient.

5. Konfigurierbares Feldgerät nach Anspruch 3, **dadurch gekennzeichnet, dass** mindestens ein Funktionsmodul zur Generierung des Ausgabewerts für die Kommunikationsschaltung (KS) dient.

6. Konfigurierbares Feldgerät nach Anspruch 5, **dadurch gekennzeichnet, dass** das Funktionsmodul zur Generierung des Ausgabewerts für die Kommunikationsschaltung (KS) einem Feldbuscontroller bzw, einem HART-Modem entspricht.

7. Konfigurierbares Feldgerät nach Anspruch 4, **dadurch gekennzeichnet, dass** das Funktionsmodul zur Auswertung des Messsignals ein Signalfilter ist.

8. Konfigurierbares Feldgerät nach einem der vorhergehenden Ansprüche, **dadurch gekennzeichnet, dass** ein Funktionsmodul zur Ansteuerung einer Anzeige/Bedieneinheit (L) dient.

9. Konfigurierbares Feldgerät nach einem der Ansprüche 3-8 mit einem Logikbaustein (LB), der eine Vielzahl von Logikzellen aufweist, die über elektronische Schalter verschaltet sind, **dadurch gekennzeichnet, dass** in einem statischen Bereich (SB) des Logikbausteins (LB) Funktionsmodule fest konfiguriert sind, wobei die Logikzellen dieser Funktionsmodule über permanente Verbindungen verschaltet sind, und einem dynamischen Bereich (DB) Funktionsmodule zeitweise konfiguriert sind, wobei die Logikzellen dieser Funktionsmodule über elektronische Schalter zeitweise verschaltet sind.

10. Verfahren zum Betreiben eines konfigurierbaren Feldgerätes in der Prozessautomatisierungstechnik, nach einem der vorhergehenden Ansprüche, **gekennzeichnet durch** folgenden Verfahrensschritte:
a) Ausführung eines Steuerprogramms in einem Mikrocontroller (µC) der Verarbeitungseinheit (ZV);
b) Aufruf eines Funktionsmoduls **durch** das Steuerprogramm;
c) Konfiguration des Funktionsmoduls auf dem partiell dynamisch rekonfigurierbaren Logikbaustein zur Laufzeit des Feldgeräts.

11. Verfahren nach Anspruch 10, wobei während der Systemstartphase folgende Verfahrensschritte durchgeführt werden:
a. Konfigurierung von mindestens einem Funktionsmodul mit hoher Priorität zu einem Zeitpunkt t1
b. Abarbeitung dieses Funktionsmoduls
c. Konfigurierung von mindestens einem Funktionsmodul mit mittlerer Priorität zu einem Zeitpunkt t2
d. Abarbeitung dieses Funktionsmoduls
e. Konfigurierung von mindestens einem Funktionsmodul mit geringer Priorität zu einem Zeitpunkt t3
f. Abarbeitung dieses Funktionsmoduls

12. Verfahren nach Anspruch 10, **dadurch gekennzeichnet, dass** die Anzahl der Logikschaltkreise mindestens eines Funktionsmoduls während der Systemstartphase und der Betriebsphase unterschiedlich ist.

13. Verfahren nach Anspruch 11, **dadurch gekennzeichnet, dass** Funktionsmodulen mit hoher Priorität während der Systemstartphase eine größere Anzahl von Logikschaltkreisen zur Verfügung stehen.

14. Verfahren nach einem der vorhergehenden Ansprüchen 12-13, **dadurch gekennzeichnet, dass** zu Beginn der Systemstartphases ein Mikroprozessor (µC) mit initialisierten Registern konfiguriert wird.

15. Verfahren nach Anspruch 10, **dadurch gekennzeichnet, dass** ein Testmodul, das zum Testen von Funktionsmodulen und/oder Softwarefunktionalitäten des Feldgerätes dient, konfiguriert wird.

16. Verfahren nach Anspruch 14, **dadurch gekennzeichnet, dass** das Testmodul nur während der Produktionsphase des Feldgeräts konfiguriert wird.

17. Verfahren nach Anspruch 14, **dadurch gekennzeichnet, dass** das Testmodul zyklisch oder sporadisch auf Anforderung durch das Steuerprogramm konfiguriert wird.

18. Verfahren nach Anspruch 10, **dadurch gekennzeichnet, dass** die Fläche, die ein Funktionsmodul auf dem rekonfigurierbaren Logikbaustein (LB) einnimmt, erweitert oder verringert wird.

19. Verfahren nach Anspruch 10, **dadurch gekennzeichnet, dass** das Funktionsmodul ein digitales Filter oder ein Funktionsmodul zur FFT-Berechnung ist, das aus einem Basisblock und mehreren Erweiterungsblöcken besteht.

## Claims

1. Configurable field device for process automation technology for determining a process variable
with an analog sensor circuit (SS), which can be connected to a probe (SD) designed to measure the process variables and which outputs an analog measuring signal that depends on the process variables recorded,
with a converter unit (U) downstream from the sensor circuit (SS) designed to convert the analog measuring signal to a digital measuring signal,
with a processing unit (ZV) connected to the converter unit (U), said processing unit containing function modules that are used to evaluate the measuring signal, to generate an output value for the process variable and to control the field device and with an analog communication circuit (KS) that is connected to the processing unit (ZV), said communication circuit serving to forward the output value to an external unit,
**characterized in that** the processing unit (ZV) comprises a logic module (LB), which is partly dynamically reconfigurable, on which function modules can be configured at the request of a control program running in a control unit (µC).

2. Configurable field device as claimed in Claim 1, **characterized in that** the configuration of the function modules is performed with a configuration bit stream which is loaded in the reconfigurable logic module (LB).

3. Configurable field device as claimed in Claim 2, **characterized in that** the entire processing unit (ZV) is designed as a partly dynamically reconfigurable logic module (LB) and has a dynamic and a static zone, wherein the control unit in the static zone (SB) is permanently configured, said control unit preferably being a microcontroller (µC).

4. Configurable field device as claimed in Claim 3, **characterized in that** at least one function module is used for evaluating the measuring signal.

5. Configurable field device as claimed in Claim 3, **characterized in that** at least one function module is used to generate the output value for the communication circuit (KS).

6. Configurable field device as claimed in Claim 5, **characterized in that** the function module for generating the output value for the communication circuit (KS) corresponds to a fieldbus controller or a HART modem.

7. Configurable field device as claimed in Claim 4, **characterized in that** the function module for evaluating the measuring signal is a signal filter.

8. Configurable field device as claimed in one of the previous claims, **characterized in that** a function module is used for controlling a display/operating unit (L).

9. Configurable field device as claimed in one of the Claims 3-8 with a logic module (LB) that has a multitude of logic cells, which are connected via electronic switches, **characterized in that** function modules are permanently configured in a static zone (SB) of the logic module (LB), wherein the logic cells of these function modules are connected via permanent connections, and function modules are temporarily configured in a dynamic zone (DB), wherein the logic cells of these function modules are temporarily connected via electronic switches.

10. Procedure for operating a configurable field device in process automation technology as claimed in one of the previous claims, **characterized by** the following procedural steps:
a) Execution of a control program in a microcontroller (µC) of the processing unit (ZV);
b) Calling of a function module by the control program;
c) Configuration of the function module on the partly dynamically reconfigurable logic module during field device runtime.

11. Procedure as claimed in Claim 10, wherein the following procedural steps are performed during the system start phase:
a. Configuration of at least one function module with a high priority at time t1
b. Processing of this function module
c. Configuration of at least one function module with medium priority at time t2
d. Processing of this function module
e. Configuration of at least one function module with a low priority at time t3
f. Processing of this function module

12. Procedure as claimed in Claim 10, **characterized in that** the number of logic circuits of at least one function module differs during the system start phase and the operating phase.

13. Procedure as claimed in Claim 11, **characterized in that** a higher number of logic circuits are available to function modules with a high priority during the system start phase.

14. Procedure as claimed in one of the previous Claims 12-13, **characterized in that** a microprocessor (µC) is configured with initialized registers at the start of the system start phase.

15. Procedure as claimed in Claim 10, **characterized in that** a test module, which is used to test function modules and/or software functions of the field device, is configured.

16. Procedure as claimed in Claim 14, **characterized in that** the test module is only configured during the production phase of the field device.

17. Procedure as claimed in Claim 14, **characterized in that** the test module is configured cyclically or sporadically at the request of the control program.

18. Procedure as claimed in Claim 10, **characterized in that** the space which a function module takes up on the reconfigurable logic module (LB) can be increased or decreased.

19. Procedure as claimed in Claim 10, **characterized in that** the function module is a digital filter or a function module for FFT calculation consisting of one basic block and several extension blocks.

## Revendications

1. Appareil de terrain configurable pour la technique d'automatisation des process, destiné à la détermination d'une grandeur process
avec un circuit de capteur analogique (SS), pouvant être relié avec une sonde (SD) destinée à mesurer les grandeurs process et qui délivre un signal de mesure analogique variable en fonction des grandeurs process mesurées,
avec une unité de convertisseur (U) couplée en aval du circuit de capteur (SS), destinée à la conversion du signal de mesure analogique en un signal de mesure numérique,
avec une unité de traitement (ZV) reliée avec l'unité de convertisseur (U), unité de traitement dans laquelle sont prévus des modules de fonction, qui servent à l'interprétation du signal de mesure, à la génération d'une valeur de sortie pour la grandeur process et à la commande de l'appareil de terrain et avec un circuit de communication analogique (KS) relié avec l'unité de traitement (ZV), qui sert à la transmission de la valeur de sortie à une unité externe,
**caractérisé en ce que** l'unité de traitement (ZV) comprend un module logique (LB) partiellement reconfigurable dynamiquement, sur lequel sont configurés des modules de fonction à la demande d'un programme de commande exécuté dans l'unité de commande (µC).

2. Appareil de terrain configurable selon la revendication 1, **caractérisé en ce que** la configuration des modules de fonction est réalisée au moyen d'un flux binaire de configuration, qui est chargé dans le module logique (LB) reconfigurable.

3. Appareil de terrain configurable selon la revendication 2, **caractérisé en ce que** l'unité de traitement (ZV) complète est conçue en tant que module logique (LB) partiellement reconfigurable dynamiquement et présente une zone dynamique et une zone statique, l'unité de commande, concernant laquelle il s'agit de préférence d'un microcontrôleur (µC), étant configurée de façon permanente dans la zone statique (SB).

4. Appareil de terrain configurable selon la revendication 3, **caractérisé en ce qu'**au moins un module de fonction sert pour l'interprétation du signal de mesure.

5. Appareil de terrain configurable selon la revendication 3, **caractérisé en ce qu'**au moins un module de fonction sert à la génération de la valeur de sortie pour le circuit de communication (KS).

6. Appareil de terrain configurable selon la revendication 5, **caractérisé en ce que** le module de fonction destiné à la génération de la valeur de sortie correspond au circuit de communication (KS) d'un contrôleur de bus de terrain ou d'un modem HART.

7. Appareil de terrain configurable selon la revendication 4, **caractérisé en ce que** le module de fonction destiné à l'interprétation du signal de mesure est un filtre de signal.

8. Appareil de terrain configurable selon l'une des revendications précédentes, **caractérisé en ce qu'**un module de fonction sert à la commande d'une unité d'affichage / de commande (L).

9. Appareil de terrain configurable selon l'une des revendications 3 à 8 avec un module logique (LB), qui présente un grand nombre de cellules logiques, qui sont couplées par l'intermédiaire de commutateurs électroniques, **caractérisé en ce que** dans une zone statique (SB) du module logique (LB), des modules de fonction sont configurés de façon fixe, les cellules logiques de ces modules de fonction étant couplées par l'intermédiaire de liaisons permanentes, et **en ce que** sont configurés temporairement des modules de fonction dans une zone dynamique (DB), les cellules logiques de ces modules de fonction étant couplées temporairement par l'intermédiaire de commutateurs électroniques.

10. Procédé destiné à l'exploitation d'un appareil de terrain configurable dans la technique d'automatisation des process, selon l'une des revendications suivantes, **caractérisé par** les étapes de procédé suivantes :
a) Exécution d'un programme de commande dans un microprocesseur (µC) de l'unité de traitement (ZV) ;
b) Appel d'un module de fonction par le programme de commande ;
c) Configuration du module de fonction sur le module logique partiellement reconfigurable dynamiquement, pendant le temps de fonctionnement de l'appareil de terrain.

11. Procédé selon la revendication 10, pour lequel les étapes de procédé suivantes sont exécutées pendant la phase de démarrage du système :
a. Configuration d'au moins un module de fonction avec une priorité élevée à un instant t1
b. Traitement de ce module de fonction
c. Configuration d'au moins un module de fonction avec une priorité moyenne à un instant t2
d. Traitement de ce module de fonction
e. Configuration d'au moins un module de fonction avec une priorité faible à un instant t3
f. Traitement de ce module de fonction

12. Procédé selon la revendication 10, **caractérisé en ce que** le nombre de circuits logiques diffère d'au moins un module de fonction pendant la phase de démarrage du système et la phase de fonctionnement.

13. Procédé selon la revendication 11, **caractérisé en ce que** les modules de fonction de priorité élevée disposent d'un nombre de circuits logiques supérieur pendant la phase de démarrage du système.

14. Procédé selon l'une des revendications précédentes 12-13, **caractérisé en ce qu'**au début de la phase de démarrage du système, un microprocesseur (µC) est configuré avec des registres initialisés.

15. Procédé selon la revendication 10, **caractérisé en ce qu'**est configuré un module de test, qui sert au test de modules de fonction et/ou de fonctionnalités logicielles de l'appareil de terrain.

16. Procédé selon la revendication 14, **caractérisé en ce que** le module de test n'est configuré que pendant la phase de production de l'appareil de terrain.

17. Procédé selon la revendication 14, **caractérisé en ce que** le module de test est configuré de façon cyclique ou sporadique, sur demande, par le programme de commande.

18. Procédé selon la revendication 10, **caractérisé en ce que** la zone qu'occupe un module de fonction dans le module logique (LB) reconfigurable est étendue ou réduite.

19. Procédé selon la revendication 10, **caractérisé en ce que** le module de fonction est un filtre numérique ou un module de fonction destiné au calcul FFT, lequel se compose d'un bloc de base et de plusieurs blocs d'extension.
